# EUROPEAN PATENT SPECIFICATION

(11) **EP 4 607 210 B1**
(45) Date of publication and mention of the grant of the patent: **21.10.2026**
(21) Application number: 24159318.5
(22) Date of filing: 23.02.2024
(51) Int. Cl.: G01R 29/08

(54) **PLANE WAVE SYNTHESIS SYSTEM, METHOD FOR SYNTHESIZING A PLANE WAVE, AND METHOD FOR TESTING RF EQUIPMENT**
SYSTEM ZUR SYNTHESE EBENER WELLEN, VERFAHREN ZUR SYNTHESE EINER EBENEN WELLE UND VERFAHREN ZUM TESTEN VON HF-AUSRÜSTUNG
SYSTÈME DE SYNTHÈSE D'ONDE PLANE, PROCÉDÉ DE SYNTHÈSE D'UNE ONDE PLANE ET PROCÉDÉ DE TEST D'ÉQUIPEMENT RF

(43) Date of publication of application: 27.08.2025
(73) Proprietor: Rohde & Schwarz GmbH & Co. KG, 81671 München (DE)
(72) Inventor: TANKIELUN, Adam, 85521 Ottobrunn (DE); SAALA, Gerd, 83026 Rosenheim (DE)
(74) Representative: Novagraaf Group

(56) References cited:
- EP-A1- 3 182 619
- EP-A1- 3 306 327
- WO-A1-2020/107362
- CN-A- 111 147 160
- CN-U- 217 112 518
- JP-A- 2022 184 131
- US-A1- 2010 026 574
- US-A1- 2019 128 999

## Description

### TECHNICAL FIELD

The disclosure relates to a plane wave synthesis system. Further, the present disclosure relates to a method for synthesizing a plane wave, and a method for testing RF equipment.

### BACKGROUND

Although applicable to any type of plane wave synthesizer, the present disclosure will mainly be described in conjunction with plane wave synthesizers for testing RF equipment, like cellular network base stations.

The development of RF equipment, like cellular base stations, requires performing extensive testing of the RF equipment. Such testing may be performed e.g., in anechoic chambers with respective signal generators and receivers. Respective testing sites may also be called compact antenna test range, also called CATR. However, the larger the RF equipment, the larger the CATR needs to be.

Document WO 2020 / 107 362 A1 discloses a plane wave synthesizer with multiple synthesizer units that each comprise multiple antenna elements.

There is a need for providing more compact testing systems for RF equipment.

### SUMMARY

The above stated problem is solved by the features of the independent claims. It is understood, that independent claims of a claim category may be formed in analogy to the dependent claims of another claim category.

The present disclosure is based on the finding that performing tests on large RF equipment, like cellular network base stations, requires test equipment that is capable of generating a quiet zone that is large enough to fully accommodate the RF equipment.

So called Over-The-Air, OTA, testing determines the performance of RF equipment in the Far-Field, FF. The FF condition may usually only be achieved at sufficient distance between the RF equipment and the respective measurement antenna, where the wave-front radiated by the RF equipment or the measurement antenna approximates a plane- wave. For (electrically) large devices plane wave generators or synthesizer, PWG or PWS, may be used to measure or generate such a plane wave in a respective quiet zone.

Modern cellular network base stations may have a height of up to 3m or more. Such devices may be considered to be "electrically large". The quiet zone required for testing such RF equipment, consequently, needs to be large enough to accommodate such RF equipment. Respective compact antenna test ranges, CATR, are huge and complex.

The present disclosure takes into account that modern RF equipment may be huge, and provides a simple solution to generate quiet zones that may accommodate huge RF equipment.

To this end, the plane wave synthesis system according to the present disclosure comprises at least two plane wave synthesizer units. In the following, the aspects of the present disclosure will be described mostly in conjunction with the plane wave synthesis system comprising two plane wave synthesizer units. However, any number of plane wave synthesizer units larger than two is also possible. The explanations regarding two plane wave synthesizer units apply to embodiments with more than two plane wave synthesizer units mutatis mutandis.

Each one of the plane wave synthesizer units comprises a plurality of antenna elements that are arranged at predetermined positions relative to or in a plane of main extension of the respective plane wave synthesizer unit. The plane of main extension may be defined e.g., by a mechanical plate that holds the single antenna elements. Any other arrangement that mechanically holds the single antenna elements is also possible. Generally, the antenna elements may be arranged in or on the plane of main extension. In embodiments, the single antenna elements may also be arranged at predetermined positions relative to the plane of main extension.

Each one of the plane wave synthesizer units comprises a signal input for receiving an input signal that is then provided to the single antenna elements for radiating a respective RF signal.

While the same RF signal may be provided to each one of the plane wave synthesizer units, the single plane wave synthesizer units are configured based on the relative positions between them, such that the combined radiated RF signals form a respective combined quiet zone. In such a quiet zone, the radiated RF signals from all the plane wave synthesizer units of the plane wave synthesis system overlap, therefore, creating a plane wave in the quiet zone.

In the plane wave synthesis system, each one of the plane wave synthesizer units may be individually calibrated e.g., by the manufacturer of the plane wave synthesizer units.

Calibrating the plane wave synthesizer units comprises adapting or configuring each one of the plane wave synthesizer units such that the respective plane wave synthesizer unit emits predefined RF signals when provided with a respective input signal. Such a configuration may e.g., compensate variations or inaccuracies in the placement of the single antenna elements, and the radiation patterns of the single antenna elements of a respective plane wave synthesizer unit. This may be achieved by configuring respective elements within the respective plane wave synthesizer unit, like attenuators, amplifiers, and phase shifters.

The single plane wave synthesizer units may, therefore, be pre-calibrated or individually calibrated plane wave synthesizer units.

Such plane wave synthesizer units may then be, as already indicated above, configured based on the relative positions between the plane wave synthesizer units. For example, an optimization algorithm may be applied that optimizes e.g., beamforming vectors or beamforming weights for the single antenna elements of all the plane wave synthesizer units in the plane wave synthesis system.

The plane wave synthesis system may comprise means for determining the relative positions between the single plane wave synthesizer units. The single plane wave synthesizer units may e.g., be mounted on mechanical carrier arrangements that may serve to mechanically position the plane wave synthesizer units. Such mechanical carrier arrangements may comprise sensors or other means to determine the positions of the single plane wave synthesizer units or the single antenna elements of the plane wave synthesizer units.

In embodiments, the plane wave synthesis system may comprise an optical measurement system for determining the relative positions of the plane wave synthesizer units. Such an optical measurement system may comprise a camera that identifies markers on the plane wave synthesizer units or the plane wave synthesizer units themselves, or a laser-based measurement system.

With the plane wave synthesis system, it is possible to provide users with a solution to create plane waves in a quiet zone with an increased size compared to known plane wave synthesizers. Since multiple pre-calibrated plane wave synthesizer units may be used, the plane wave synthesis system is easy to transport, and simple to install. Further, such a plane wave synthesis system may be manufactured more cost-effective, since the single plane wave synthesizer units may be individually calibrated in small test/measurement systems.

Further embodiments of the present disclosure are subject of the further dependent claims and of the following description, referring to the drawings.

In the following, the dependent claims referring directly or indirectly to claim 1 are described in more detail. For the avoidance of doubt, the features of the dependent claims relating to the plane wave synthesis system can be combined in all variations with each other and the disclosure of the description is not limited to the claim dependencies as specified in the claim set. Further, the features of the other independent claims may be combined with any of the features of the dependent claims relating to the plane wave synthesis system in all variations, wherein respective method steps perform the function of the respective apparatus elements.

In an embodiment, which can be combined with all other embodiments, each one of the antenna elements may be one of single-polarized or dual-polarized.

Plane wave synthesizer units of the plane wave synthesis system may be single-polarized i.e., comprise antenna elements that are only polarized in one direction.

Further, plane wave synthesizer units of the plane wave synthesis system may be dual-polarized i.e., comprise antenna elements that are polarized in two directions. Such plane wave synthesizer units may be vertically/horizontally (V/H) dual-polarized i.e., with an angle of 90° between the two polarization directions.

With dual-polarized plane wave synthesizer units, the plane wave synthesizer units may be configured to generate the combined quiet zone in both polarization directions.

In another embodiment, which can be combined with all other embodiments, the plane wave synthesis system may further comprise at least one signal distribution network to provide input signals for the antenna elements of the at least two plane wave synthesizer units, especially based on the relative positions, i.e., based on position information that at least characterizes the spatial arrangement of the at least two plane wave synthesizer units with respect to each other.

The signal distribution network of the plane wave synthesis system may comprise individual signal distribution networks in each one of the plane wave synthesizer units. Such individual signal distribution networks may be pre-calibrated, as explained above, for each plane wave synthesizer unit.

When used with dual-polarized plane wave synthesizer units, two signal distribution networks or a signal distribution network with two branches may be provided.

The above-mentioned individual calibration of the single plane wave synthesizer units may e.g., be provided via a respective configuration of the single elements of the individual signal distribution network of the respective plane wave synthesizer unit, especially elements like attenuators, amplifiers, and phase shifters.

In a further embodiment, which can be combined with all other embodiments, the at least one signal distribution network may comprise a power splitter configured to split an input signal into a dedicated input signal for each one of the at least two plane wave synthesizer units.

When used with dual-polarized plane wave synthesizer units, two power splitters may be provided, one for each polarization. When used with single-polarized plane wave synthesizer units, a single power splitter may be provided.

The power splitter(s) may be configured to evenly split the input signal between all the plane wave synthesizer units. In the case of two plane wave synthesizer units, each plane wave synthesizer unit may be provided with 50% of the power of the input signal. With three plane wave synthesizer units, each plane wave synthesizer unit may be provided with 33,33... % of the power of the input signal, and so on.

The signal distribution network may be provided such that the signal delays from the input port of the power splitter to the single plane wave synthesizer units is as equal as possible, and such that the signal attenuation is as equal as possible for all plane wave synthesizer units. This may be achieved e.g., by using the same type of cables, and cables of the same length for all plane wave synthesizer units. The input signal is then distributed to all the plane wave synthesizer units as symmetrically as possible.

In another further embodiment, which can be combined with all other embodiments, the at least one signal distribution network may be configured to set, in a calibration mode, for each one of the input signals of the antenna elements a phase shift and an attenuation, especially based at least on one of characteristics of at least one of the antenna elements, signal lines providing input signals to the antenna elements, the power splitter, and the relative positions.

In the calibration mode, a system wide calibration for the plane wave synthesis system may be applied to the single antenna elements of the plane wave synthesizer units in addition to the pre-calibration or individual calibration of the single plane wave synthesizer units.

To this end, at least the phase shift and the attenuation or amplification for each one of the antenna elements may be configured.

In order to determine the single calibration parameters, properties of the plane wave synthesis system may be measured or determined mathematically. For example, the properties of the power splitter(s) and the signal lines from the power splitters to the single plane wave synthesizer units may be measured. Each power splitter with the respective signal lines may e.g., be treated like a 3-port device, and the respective S-parameters may be determined. The S-parameters may e.g., be determined with a measurement device, like a Vector Network Analyzer, also called VNA.

In a further embodiment, which can be combined with all other embodiments, setting the phase shift and attenuation with the at least one signal distribution network may comprise determining the phase shift and attenuation based on an optimization algorithm that is configured to optimize the phase shift and attenuation according to predetermined characteristics of the combined quite zone. The optimization algorithm may have the goal of synthesizing a plane-wave as uniform as possible with the highest magnitude level.

In order to apply an optimization algorithm, a formula may be stablished that describes the electric field that is generated by the plane wave synthesizer units. With such a formula, the optimization algorithm may optimize the configuration parameters e.g., in the form of beamforming vectors, for the single antenna elements such that the resulting quiet zone meets the respective requirements regarding size and the quality of the plane wave in the quiet zone.

When defining the formula, one of the plane wave synthesizer units may be defined as the base plane wave synthesizer unit. For the following example, we will define the plane wave synthesizer unit A as this base plane wave synthesizer unit. A second plane wave synthesizer unit is defined as plane wave synthesizer unit B.

The formula that mathematically describes the electric field may calculate the field at the position r, E(r), as a factor T_{A} that is the signal output by the signal splitter for the base plane wave synthesizer unit A divided by the input signal, wherein this factor is multiplied by a factor s that is the input signal to the power splitter divided by a reference signal V_{REF}. The result of this multiplication is the multiplied by a sum that is formed for all antenna elements. The sum comprises the electrical field generated by an antenna element of the base plane wave synthesizer unit at position r, E_{A,i} (r), multiplied by beamforming weight factor w_{A,i} plus the electrical field generated by an antenna element of the second plane wave synthesizer unit at position r - r_{B0}, E_{B,i} (r - r_{B0}), multiplied by beamforming weight factor w_{B,i} and by beamforming weight factor w_{B0}. $E \left(r\right) s = {T}_{A} s {\sum }_{i = 1}^{I} \left({E}_{A , i}\left(r\right){w}_{A , i}+{E}_{B , i}\left(r-{r}_{B 0}\right){w}_{B 0}{w}_{B , i}\right)$

The vector r_{B0} describes the relative position of the second plane wave synthesizer unit in the global coordinate system of the plane wave synthesis system. If the base plane wave synthesizer unit is not positioned in the origin of this global coordinate system of the plane wave synthesis system, a further vector r_{A0} may be provided for the base plane wave synthesizer unit. The weight factor w_{B0} is defined as T_{A} divided by T_{B}. T_{B} is the signal output by the signal splitter for the second plane wave synthesizer unit B divided by the input signal.

The pre-calibration or individual calibration of the single plane wave synthesizer units may e.g., be provided implicitly to the optimization algorithm in the values E_{A,i}, and E_{B,i}. A possible optimization algorithm for excitation weights are described e.g., in O. M. Bucci, M. D. Migliore, G. Panariello and D. Pinchera, "Plane-Wave Generators: Design Guidelines, Achievable Performances and Effective Synthesis," in IEEE Transactions on Antennas and Propagation, vol. 61, no. 4, pp. 2005-2018, April 2013, doi: 10.1109/TAP.2012.2233453.

**In** another embodiment, which can be combined with all other embodiments, the at least two plane wave synthesizer units are arranged next to each other, especially with their planes of main extension in parallel.

The at least two plane wave synthesizer units being arranged next to each other may comprise any combination of the plane wave synthesizer units being arranged with corresponding edges of the at least two plane wave synthesizer units being arranged next to each other. The edges may at least one of be in parallel, be positioned with the (mechanically) minimum possible distance to each other, and be positioned touching each other.

**In** a further embodiment, which can be combined with all other embodiments, the at least two plane wave synthesizer units may be arranged at least one of with a predetermined distance next to each other, and/or with a predetermined angle to each other, especially with their planes of main extension not in parallel.

The at least two plane wave synthesizer units may be arranged with their corresponding edges arranged with the predetermined distance next to each other. The edges may be parallel, with the edges positioned with the predetermined distance to each other. Arranging the single plane wave synthesizer units with a predetermined distance to each other allows easily handling the single plane wave synthesizer units.

When positioned with an angle to each other, the planes of main extension or the normal of the planes of main extension of the plane wave synthesizer units may comprise the respective angle to each other.

In an embodiment, which can be combined with all other embodiments, the at least two plane wave synthesizer units may be arranged rotatably at least one of around a rotation axis that is parallel to the normal of the plane of main extension of the respective plane wave synthesizer unit and around a rotation axis that is orthogonal to the normal of the plane of main extension of the respective plane wave synthesizer unit.

Especially, with the above-mentioned distance and/or angle between them, the plane wave synthesizer units may be rotated about an axis that is parallel to the normal of the plane of main extension of the plane wave synthesizer unit, without moving any one of the other plane wave synthesizer units to make space for such a rotation.

Rotating the plane wave synthesizer units allows changing the polarization of the generated electric field with respect to a device under test mechanically by rotating the single plane wave synthesizer units e.g., by 90°.

In another embodiment, which can be combined with all other embodiments, the plane wave synthesis system may further comprise electromagnetic coupling reduction means, especially a plate of conductive material or RF absorbing material, arranged between at least two of the at least two plane wave synthesizer units.

By providing the electromagnetic coupling reduction means between two of the plane wave synthesizer units, the separability of the respective plane wave synthesizer units is improved. As a consequence, the quality of the plane wave in the quiet zone may be improved.

Such an electromagnetic coupling reduction means may comprise e.g., a simple plate made of an electrically conductive material or RF absorbing material. Such a plate may be electrically floating i.e., not connected to a reference potential. Such a plate may also be grounded or coupled to any other reference potential.

### BRIEF DESCRIPTION OF THE DRAWINGS

For a more complete understanding of the present disclosure and advantages thereof, reference is now made to the following description taken in conjunction with the accompanying drawings. The disclosure is explained in more detail below using exemplary embodiments which are specified in the schematic figures of the drawings, in which:
Figure 1 shows a block diagram of an embodiment of a plane wave synthesis system according to the present disclosure;
Figure 2 shows a block diagram of another embodiment of a plane wave synthesis system according to the present disclosure;
Figure 3 shows a block diagram of another embodiment of a plane wave synthesis system according to the present disclosure;
Figure 4 shows a block diagram of another embodiment of a plane wave synthesis system according to the present disclosure;
Figure 5 shows a block diagram of another embodiment of a plane wave synthesis system according to the present disclosure;
Figure 6 shows a block diagram of another embodiment of a plane wave synthesis system according to the present disclosure;
Figure 7 shows a block diagram of another embodiment of a plane wave synthesis system according to the present disclosure;
Figure 8 shows a flow diagram of an embodiment of a method according to the present disclosure; and
Figure 9 shows a flow diagram of an embodiment of another method according to the present disclosure.

In the figures like reference signs denote like elements unless stated otherwise.

### DETAILED DESCRIPTION OF THE DRAWINGS

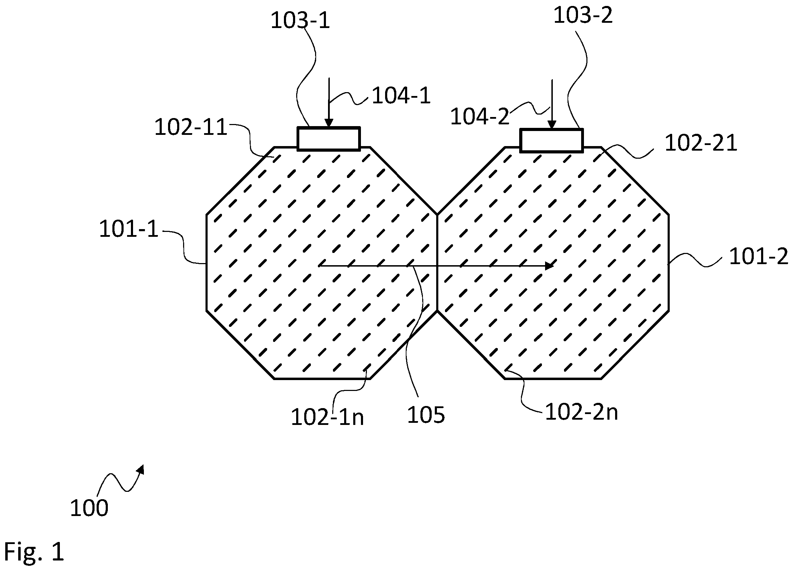

Figure 1 shows a plane wave synthesis system 100. The plane wave synthesis system 100 exemplarily comprises two plane wave synthesizer units 101-1, 101-2. Each one of the plane wave synthesizer units 101-1, 101-2 comprises a plurality of antenna elements 102-11 - 102-1n, 102-21 - 102-2n that are arranged in a plane of main extension of the respective plane wave synthesizer unit 101-1, 101-2, which is the drawing plane of figure 1. It is understood, that in other embodiments, more than two plane wave synthesizer units may be provided.

The single antenna elements 102-11 - 102-1n, 102-21 - 102-2n are coupled to a signal input 103-1, 103-2 of the respective plane wave synthesizer unit 101-1, 101-2, which is not explicitly shown for sake of clarity.

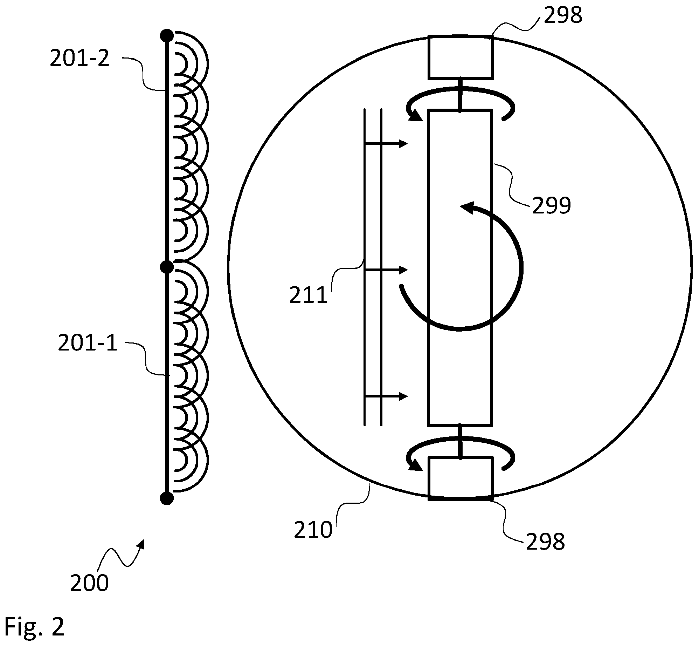

The two plane wave synthesizer units 101-1, 101-2 are configured based on the relative position 105 between the two plane wave synthesizer units 101-1, 101-2 to generate a plane wave in a combined quiet zone, see figure 2.

During operation, each one of the plane wave synthesizer units 101-1, 101-2 receives an input signal 104-1, 104-2 via a respective signal input 103-1, 103-2, and provides individual emission signals to the single antenna elements 102-11 - 102-1n, 102-21 - 102-2n via a respective internal signal distribution network (not shown) that may at the same time apply respective beamforming parameters to the individual emission signals.

**In** figure 1 the plane wave synthesizer units 101-1, 101-2 are octagonal in shape in their plane of main extension. It is understood, that in other embodiments, any other shape is possible. The plane wave synthesizer units may e.g., comprise a round shape, a rectangular shape, or a shape with more than four sides, which may have the same length.

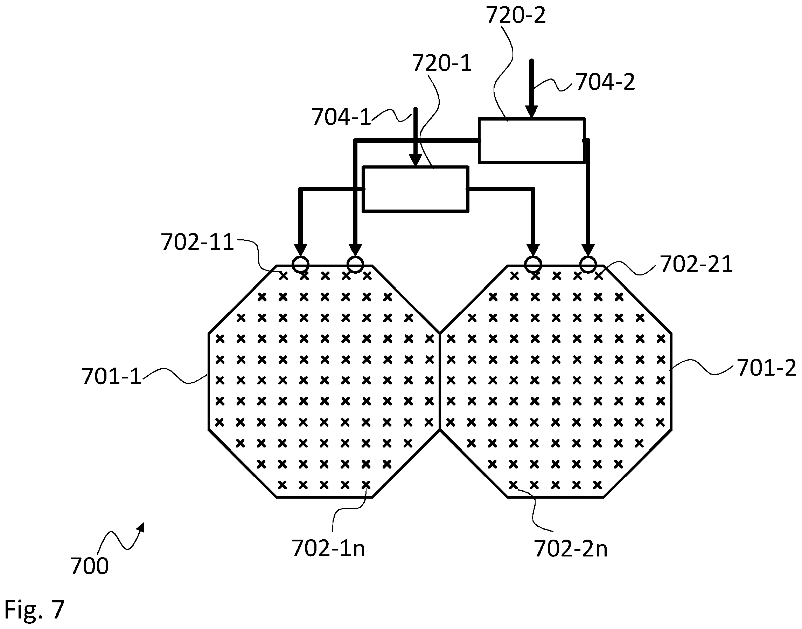

In the plane wave synthesis system 100 each one of the antenna elements 102-11 - 102-1n, 102-21 - 102-2n is single-polarized. A plane wave synthesis system with dual polarized antenna elements in shown e.g., in figure 7.

Figure 2 shows a plane wave synthesis system 200. The plane wave synthesis system 200 is shown in a top view i.e., looking onto the vertical axis of figure 1. The plane wave synthesis system 200 may be an implementation analogous to the plane wave synthesis system 100, or any other embodiment of the plane wave synthesis system shown herein.

The plane wave synthesis system 200 comprises two plane wave synthesizer units 201-1, 201-2 that are arranged next to each other with no separation between them and with their planes of main extension in parallel.

In front of the plane wave synthesis system 200 a quite zone 210 with a plane wave 211 is schematically shown. In the quite zone 210 a cellular base station 299 is provided as device under test. The cellular base station 299 is fixed to a mechanical fixture 298 that allows rotating the cellular base station 299 in at least two axes, the vertical axis and the axis pointing out of figure 2.

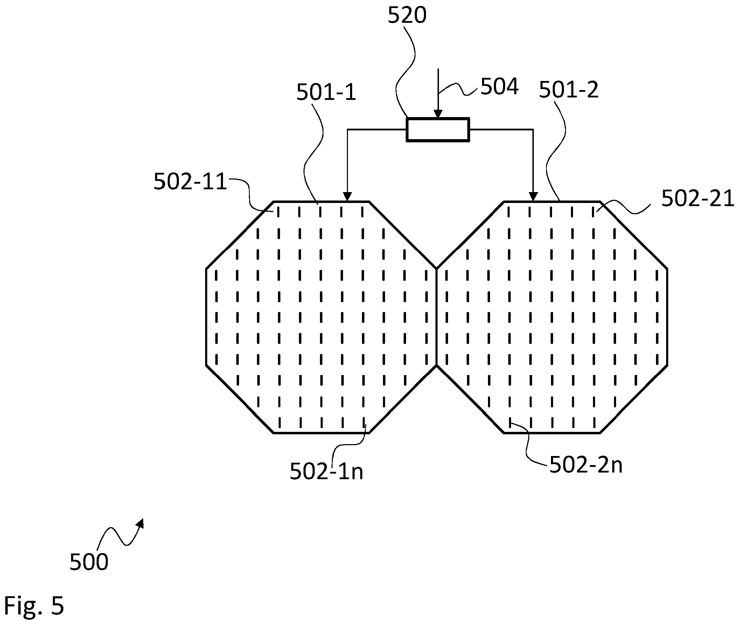

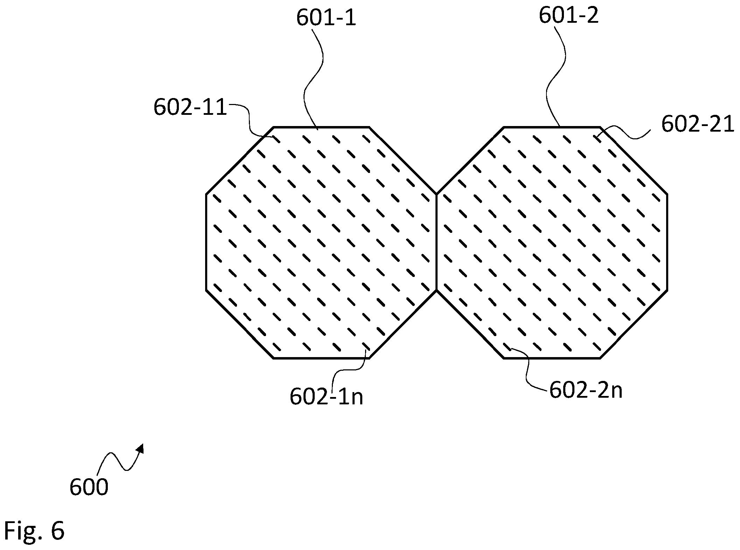

The plane wave synthesizer units 201-1, 201-2 may touch each other on the edges that face towards each other. Although not shown, the plane wave synthesizer units 201-1, 201-2 may be mounted on a mechanical arrangement that allows rotating the plane wave synthesizer units 201-1, 201-2 around an axis that is parallel to the normal of their plane of main extension. As will be explained below with regard to figures 5 and 6, this allows easily changing the polarization of the plane wave 211.

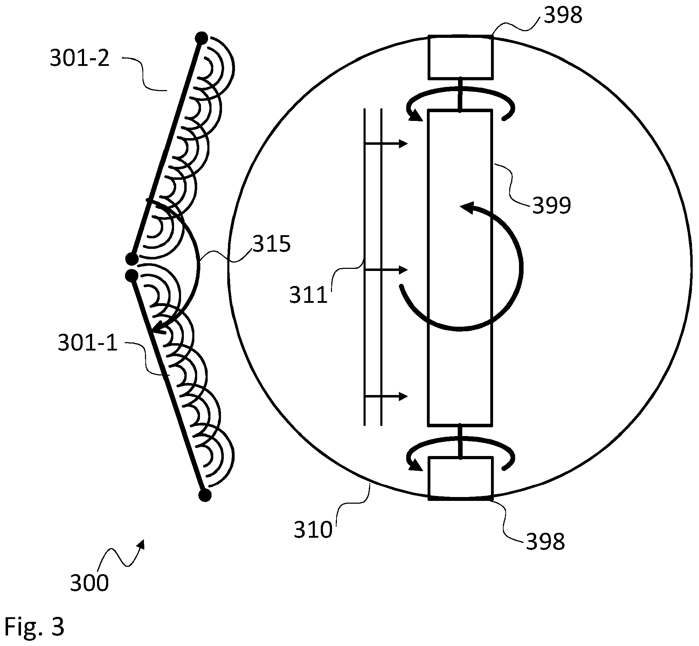

Figure 3 shows a plane wave synthesis system 300. The plane wave synthesis system 300 is shown in a top view i.e., looking onto the vertical axis of figure 1. The plane wave synthesis system 300 may be an implementation analogous to the plane wave synthesis system 100, or any other embodiment of the plane wave synthesis system shown herein.

The plane wave synthesis system 300 comprises two plane wave synthesizer units 301-1, 301-2 that are arranged next to each other with a predefined angle 315 between their planes of main extension. Further, a gap is visible between the plane wave synthesizer units 301-1, 301-2.

In front of the plane wave synthesis system 300 a quite zone 310 with a plane wave 311 is schematically shown. In the quite zone 310 a cellular base station 399 is provided as device under test. The cellular base station 399 is fixed to a mechanical fixture 398 that allows rotating the cellular base station 399 in at least two axes, the vertical axis and the axis pointing out of figure 3.

Although not shown, the plane wave synthesizer units 301-1, 301-2 may be mounted on a mechanical arrangement that allows rotating the plane wave synthesizer units 301-1, 301-2 around an axis that is parallel to the normal of their plane of main extension. As will be explained below with regard to figures 5 and 6, this allows easily changing the polarization of the plane wave 311.

In contrast to the plane wave synthesis system 200, with the plane wave synthesis system 300 the single plane wave synthesizer units 301-1, 301-2 may be rotated without colliding with the other plane wave synthesizer unit 301-1, 301-2. In the plane wave synthesis system 200 this would be the case for all but round plane wave synthesizer units 201-1, 201-2.

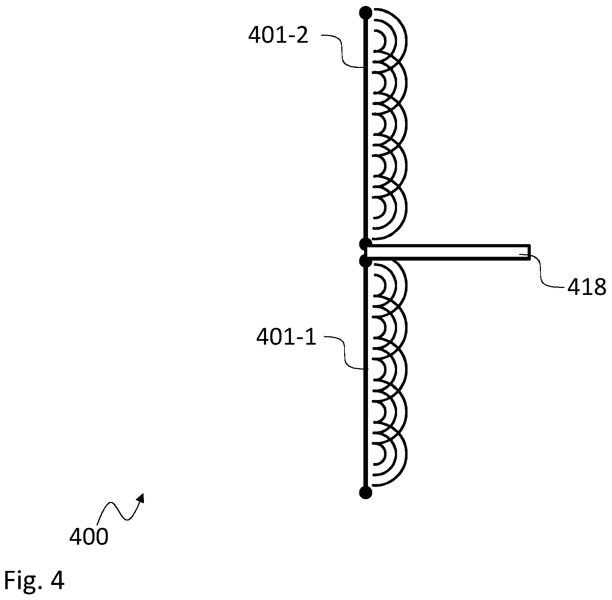

Figure 4 shows a plane wave synthesis system 400. The plane wave synthesis system 400 is shown in a top view i.e., looking onto the vertical axis of figure 1. The plane wave synthesis system 400 may be an implementation analogous to the plane wave synthesis system 100, or any other embodiment of the plane wave synthesis system shown herein.

The plane wave synthesis system 400 comprises two plane wave synthesizer units 401-1, 401-2 that are arranged next to each other with a separation or gap between them and with their planes of main extension in parallel. In the gap or separation an electromagnetic coupling reduction means 418 is provided.

The electromagnetic coupling reduction means 418 serves for increasing the separability of the plane wave synthesizer units 401-1, 401-2, and may be provided as plate made of a conductive material or RF absorbing material.

The electromagnetic coupling reduction means 418 may be combined with or provided in any one of the embodiments of the plane wave synthesis system disclosed herein.

Figure 5 shows a plane wave synthesis system 500 in a front view. The plane wave synthesis system 500 is based on plane wave synthesis system 100. However, the principles explained with regard to figure 5 may be applied to any other embodiment of the plane wave synthesis system disclosed herein. The explanations provided herein regarding any one of the plane wave synthesis systems also apply mutatis mutandis to the plane wave synthesis system 500.

The plane wave synthesis system 500 exemplarily comprises two plane wave synthesizer units 501-1, 501-2. Each one of the plane wave synthesizer units 501-1, 501-2 comprising a plurality of antenna elements 502-11 - 502-1n, 502-21 - 502-2n that are arranged in a plane of main extension of the respective plane wave synthesizer unit 501-1, 501-2, which is the drawing plane of figure 5. It is understood, that in other embodiments, more than two plane wave synthesizer units may be provided.

In the plane wave synthesis system 100 the polarization of the single antenna elements 102-11 - 102-1n, 102-21 - 102-2n is in a 45° angle. In contrast, in the plane wave synthesis system 500, the polarization of the single antenna elements 502-11 - 502-1n, 502-21 - 502-2n is vertical or in a 90° angle. This may be achieved by simply rotating the plane wave synthesizer units 501-1, 501-2.

The plane wave synthesis system 500 further comprises a power splitter 520 that receives an input signal 520. The input signal 504 is split by the power splitter 520 into individual signals that are provided to the single plane wave synthesizer units 501-1, 501-2.

The power splitter 520 is shown in the plane wave synthesis system 500 only. However, the power splitter 520 may also be used with any other embodiment of the plane wave synthesis system disclosed herein.

Figure 6 shows a plane wave synthesis system 600. The plane wave synthesis system 600 is based on plane wave synthesis system 100. However, the principles explained with regard to figure 6 may be applied to any other embodiment of the plane wave synthesis system disclosed herein. The explanations provided herein regarding any one of the plane wave synthesis systems also apply mutatis mutandis to the plane wave synthesis system 600.

The plane wave synthesis system 600 exemplarily comprises two plane wave synthesizer units 601-1, 601-2. Each one of the plane wave synthesizer units 601-1, 601-2 comprising a plurality of antenna elements 602-11 - 602-1n, 602-21 - 602-2n that are arranged in a plane of main extension of the respective plane wave synthesizer unit 601-1, 601-2, which is the drawing plane of figure 6. It is understood, that in other embodiments, more than two plane wave synthesizer units may be provided.

In the plane wave synthesis system 100 the polarization of the single antenna elements 102-11 - 102-1n, 102-21 - 102-2n is in a 45° angle. In contrast, in the plane wave synthesis system 600, the polarization of the single antenna elements 602-11 - 602-1n, 602-21 - 602-2n is in a -45° angle. This may be achieved by simply rotating the plane wave synthesizer units 601-1, 601-2.

Figure 7 shows a plane wave synthesis system 700. The plane wave synthesis system 700 is based on the plane wave synthesis system 500. However, the principles explained with regard to figure 7 may be applied to any other embodiment of the plane wave synthesis system disclosed herein. The explanations provided herein regarding any one of the plane wave synthesis systems also apply mutatis mutandis to the plane wave synthesis system 700.

The plane wave synthesis system 700 exemplarily comprises two plane wave synthesizer units 701-1, 701-2. Each one of the plane wave synthesizer units 701-1, 701-2 comprising a plurality of antenna elements 702-11 - 702-1n, 702-21 - 702-2n that are arranged in a plane of main extension of the respective plane wave synthesizer unit 701-1, 701-2, which is the drawing plane of figure 7. It is understood, that in other embodiments, more than two plane wave synthesizer units may be provided.

The single antenna elements 702-11 - 702-1n, 702-21 - 702-2n, in contrast to the antenna elements 502-11 - 502-1n, 502-21 - 502-2n, are dual-polarized.

Consequently, the plane wave synthesis system 700 further comprises two power splitters 720-1, 720-2 that each receive an input signal 704-1, 704-2. The input signals 704-1, 704-2 are split by the power splitters 720-1, 720-2 into individual signals that are provided to the single plane wave synthesizer units 701-1, 701-2.

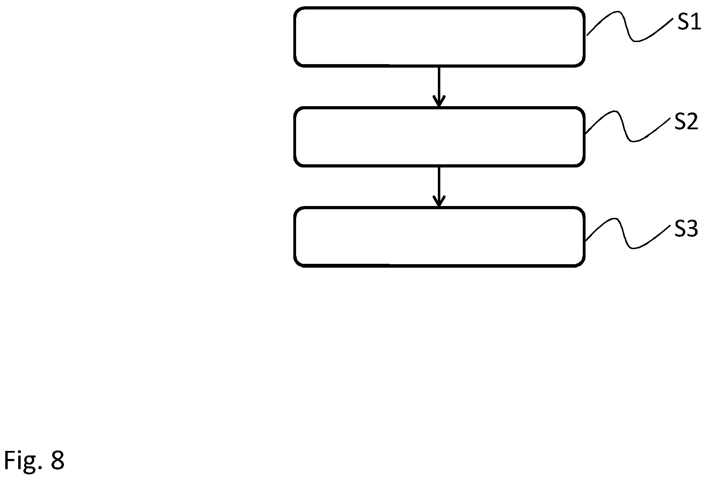

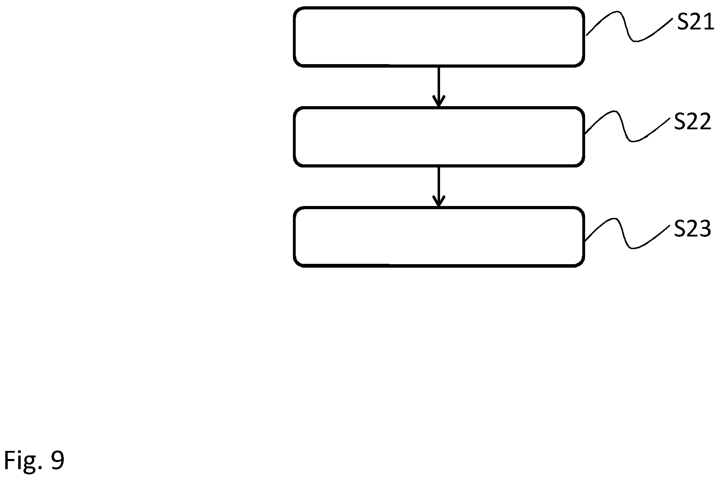

For sake of clarity in the following description of the method-based figures 8 and 9 the reference signs used above in the description of apparatus-based figures 1 to 7 will be maintained.

Figure 8 shows a flow diagram of a method for synthesizing a plane wave. The method comprises arranging S1 at least two plane wave synthesizer units 101-1, 101-2, 201-1, 201-2, 301-1, 301-2, 401-1, 401-2, 501-1, 501-2, 601-1, 601-2, 701-1, 701-2 next to each other, each one of the plane wave synthesizer units 101-1, 101-2, 201-1, 201-2, 301-1, 301-2, 401-1, 401-2, 501-1, 501-2, 601-1, 601-2, 701-1, 701-2 comprising a plurality of antenna elements 102-11 - 102-1n, 102-21 - 102-2n, 502-11 - 502-1n, 502-21 - 502-2n, 602-11 - 602-1n, 602-21 - 602-2n, 702-11 - 702-1n, 702-21 - 702-2n that are arranged in a plane of main extension of the respective plane wave synthe sizer unit 101-1, 101-2, 201-1, 201-2, 301-1, 301-2, 401-1, 401-2, 501-1, 501-2, 601-1, 601-2, 701-1, 701-2 and that are coupled to a signal input 103-1, 103-2 of the respective plane wave synthesizer unit 101-1, 101-2, 201-1, 201-2, 301-1, 301-2, 401-1, 401-2, 501-1, 501-2, 601-1, 601-2, 701-1, 701-2.

The method further comprises configuring S2 the at least two plane wave synthesizer units 101-1, 101-2, 201-1, 201-2, 301-1, 301-2, 401-1, 401-2, 501-1, 501-2, 601-1, 601-2, 701-1, 701-2 based on the relative positions 105 between the at least two plane wave synthesizer units 101-1, 101-2, 201-1, 201-2, 301-1, 301-2, 401-1, 401-2, 501-1, 501-2, 601-1, 601-2, 701-1, 701-2, and providing S3 an input signal 104-1, 104-2 to the at least two plane wave synthesizer units 101-1, 101-2, 201-1, 201-2, 301-1, 301-2, 401-1, 401-2, 501-1, 501-2, 601-1, 601-2, 701-1, 701-2 to generate a plane wave 211, 311 in a combined quiet zone 210, 310.

In embodiments, the method may further comprise distributing the input signal 504 via at least one signal distribution network, especially based on the relative positions 105, to generate input signals 104-1, 104-2 for the antenna elements 102-11 - 102-1n, 102-21 - 102-2n, 502-11 - 502-1n, 502-21 - 502-2n, 602-11 - 602-1n, 602-21 - 602-2n, 702-11 - 702-1n, 702-21 - 702-2n of the at least two plane wave synthesizer units 101-1, 101-2, 201-1, 201-2, 301-1, 301-2, 401-1, 401-2, 501-1, 501-2, 601-1, 601-2, 701-1, 701-2, especially by splitting the input signal 504 to provide a dedicated input signal 104-1, 104-2 for each one of the at least two plane wave synthesizer units 101-1, 101-2, 201-1, 201-2, 301-1, 301-2, 401-1, 401-2, 501-1, 501-2, 601-1, 601-2, 701-1, 701-2.

The method may further comprise arranging electromagnetic coupling reduction means 418, especially a plate of conductive material or RF absorbing material, between at least two of the at least two plane wave synthesizer units 101-1, 101-2, 201-1, 201-2, 301-1, 301-2, 401-1, 401-2, 501-1, 501-2, 601-1, 601-2, 701-1, 701-2.

In a calibration mode, the signal distribution may be configured by setting for each one of the input signals of the antenna elements 102-11 - 102-1n, 102-21 - 102-2n, 502-11 - 502-1n, 502-21 - 502-2n, 602-11 - 602-1n, 602-21 - 602-2n, 702-11 - 702-1n, 702-21 - 702-2n a phase shift and an attenuation, especially based at least on one of characteristics of at least one of the antenna elements 102-11 - 102-1n, 102-21 - 102-2n, 502-11 - 502-1n, 502-21 - 502-2n, 602-11 - 602-1n, 602-21 - 602-2n, 702-11 - 702-1n, 702-21 - 702-2n, signal lines providing input signals 104-1, 104-2 to the antenna elements 102-11 - 102-1n, 102-21 - 102-2n, 502-11 - 502-1n, 502-21 - 502-2n, 602-11 - 602-1n, 602-21 - 602-2n, 702-11 - 702-1n, 702-21 - 702-2n, the power splitting, and the relative positions 105. In embodiments, setting the phase shift and attenuation may comprise determining the phase shift and attenuation based on an optimization algorithm that is configured to optimize the phase shift and attenuation according to predetermined characteristics of the combined quite zone.

In embodiments, the at least two plane wave synthesizer units 101-1, 101-2, 201-1, 201-2, 301-1, 301-2, 401-1, 401-2, 501-1, 501-2, 601-1, 601-2, 701-1, 701-2 may be arranged next to each other, especially with their planes of main extension in parallel. In further embodiments, the at least two plane wave synthesizer units 101-1, 101-2, 201-1, 201-2, 301-1, 301-2, 401-1, 401-2, 501-1, 501-2, 601-1, 601-2, 701-1, 701-2 may be arranged at least one of with a predetermined distance next to each other, and/or with a predetermined angle 315 to each other, especially with their planes of main extension not in parallel. In yet further embodiments, the at least two plane wave synthesizer units 101-1, 101-2, 201-1, 201-2, 301-1, 301-2, 401-1, 401-2, 501-1, 501-2, 601-1, 601-2, 701-1, 701-2 may be arranged rotatably at least one of around a rotation axis that is parallel to the normal of the plane of main extension of the respective plane wave synthesizer unit 101-1, 101-2, 201-1, 201-2, 301-1, 301-2, 401-1, 401-2, 501-1, 501-2, 601-1, 601-2, 701-1, 701-2, and around a rotation axis that is orthogonal to the normal of the plane of main extension of the respective plane wave synthesizer unit 101-1, 101-2, 201-1, 201-2, 301-1, 301-2, 401-1, 401-2, 501-1, 501-2, 601-1, 601-2, 701-1, 701-2.

Figure 9 shows a flow diagram of a method for testing RF equipment. The method comprises providing S21 a plane wave synthesis system 100, 200, 300, 400, 500, 600, 700 according to any one of the embodiments disclosed herein. The method further comprises providing S22 the RF equipment in the quiet zone 210, 310 generated by the plane wave synthesis system 100, 200, 300, 400, 500, 600, 700, and performing S23 RF tests on the RF equipment.

The processes, methods, or algorithms disclosed herein can be deliverable to/implemented by a processing device, controller, or computer, which can include any existing programmable electronic control unit or dedicated electronic control unit. Similarly, the processes, methods, or algorithms can be stored as data and instructions executable by a controller or computer in many forms including, but not limited to, information permanently stored on non-writable storage media such as ROM devices and information alterably stored on writeable storage media such as floppy disks, magnetic tapes, CDs, RAM devices, and other magnetic and optical media. The processes, methods, or algorithms can also be implemented in a software executable object. Alternatively, the processes, methods, or algorithms can be embodied in whole or in part using suitable hardware components, such as Application Specific Integrated Circuits (ASICs), Field-Programmable Gate Arrays (FPGAs), state machines, controllers or other hardware components or devices, or a combination of hardware, software and firmware components.

While exemplary embodiments are described above, it is not intended that these embodiments describe all possible forms encompassed by the claims. The words used in the specification are words of description rather than limitation, and it is understood that various changes can be made without departing from the scope of the appended claims. As previously described, the features of various embodiments can be combined to form further embodiments of the invention that may not be explicitly described or illustrated. While various embodiments could have been described as providing advantages or being preferred over other embodiments or prior art implementations with respect to one or more desired characteristics, those of ordinary skill in the art recognize that one or more features or characteristics can be compromised to achieve desired overall system attributes, depending on the specific application and implementation without departing from the scope of the appended claims.

With regard to the processes, systems, methods, heuristics, etc. described herein, it should be understood that, although the steps of such processes, etc. have been described as occurring according to a certain ordered sequence, such processes could be practiced with the described steps performed in an order other than the order described herein. It further should be understood that certain steps could be performed simultaneously, that other steps could be added, or that certain steps described herein could be omitted within the scope of the appended claims.

Accordingly, it is to be understood that the above description is intended to be illustrative and not restrictive. Many embodiments and applications other than the examples provided would be apparent upon reading the above description. The scope should be determined, not with reference to the above description, but should instead be determined by the appended claims.

All terms used in the claims are intended to be given their broadest reasonable constructions and their ordinary meanings as understood by those knowledgeable in the technologies described herein unless an explicit indication to the contrary in made herein. In particular, use of the singular articles such as "a," "the," "said," etc. should be read to recite one or more of the indicated elements unless a claim recites an explicit limitation to the contrary.

The abstract of the disclosure is provided to allow the reader to quickly ascertain the nature of the technical disclosure. It is submitted with the understanding that it will not be used to interpret or limit the scope or meaning of the claims. In addition, in the foregoing Detailed Description, it can be seen that various features are grouped together in various embodiments for the purpose of streamlining the disclosure. This method of disclosure is not to be interpreted as reflecting an intention that the claimed embodiments require more features than are expressly recited in each claim. Rather, as the following claims reflect, inventive subject matter lies in less than all features of a single disclosed embodiment. Thus, the following claims are hereby incorporated into the Detailed Description, with each claim standing on its own as a separately claimed subject matter.

While exemplary embodiments are described above, it is not intended that these embodiments describe all possible forms of the invention. Rather, the words used in the specification are words of description rather than limitation, and it is understood that various changes may be made without departing from the scope of the invention.

### LIST OF REFERENCE SIGNS

- 100, 200, 300, 400, 500, 600, 700: plane wave synthesis system
- 101-1, 101-2, 201-1, 201-2, 301-1, 301-2: plane wave synthesizer unit
- 401-1, 401-2, 501-1, 501-2, 601-1, 601-2: plane wave synthesizer unit
- 701-1, 701-2: plane wave synthesizer unit
- 102-11 - 102-1n, 102-21 - 102-2n: antenna element
- 502-11 - 502-1n, 502-21 - 502-2n: antenna element
- 602-11 - 602-1n, 602-21 - 602-2n: antenna element
- 702-11 - 702-1n, 702-21 - 702-2n: antenna element
- 103-1, 103-2: signal input
- 104-1, 104-2, 504: input signal
- 105: relative position

- 210, 310: quiet zone
- 211, 311: plane wave

- 315: predetermined angle

- 418: electromagnetic coupling reduction means

- 520, 720-1, 720-2: power splitter

- 299, 399: base station
- 298, 398: mechanical fixture

- S1 - S3, S21 - S23: method steps.

## Claims

1. Plane wave synthesis system (100, 200, 300, 400, 500, 600, 700) comprising:
at least two plane wave synthesizer units (101-1, 101-2, 201-1, 201-2, 301-1, 301-2, 401-1, 401-2, 501-1, 501-2, 601-1, 601-2, 701-1, 701-2), each one of the plane wave synthesizer units (101-1, 101-2, 201-1, 201-2, 301-1, 301-2, 401-1, 401-2, 501-1, 501-2, 601-1, 601-2, 701-1, 701-2) comprising a plurality of antenna elements (102-11 - 102-1n, 102-21 - 102-2n, 502-11 - 502-1n, 502-21 - 502-2n, 602-11 - 602-1n, 602-21 - 602-2n, 702-11 - 702-1n, 702-21 - 702-2n) that are arranged at predetermined positions relative to a plane of main extension of the respective plane wave synthesizer unit (101-1, 101-2, 201-1, 201-2, 301-1, 301-2, 401-1, 401-2, 501-1, 501-2, 601-1, 601-2, 701-1, 701-2) and that are coupled to a signal input (103-1, 103-2) of the respective plane wave synthesizer unit (101-1, 101-2, 201-1, 201-2, 301-1, 301-2, 401-1, 401-2, 501-1, 501-2, 601-1, 601-2, 701-1, 701-2);
wherein the at least two plane wave synthesizer units (101-1, 101-2, 201-1, 201-2, 301-1, 301-2, 401-1, 401-2, 501-1, 501-2, 601-1, 601-2, 701-1, 701-2) are configured based on the relative positions (105) between the at least two plane wave synthesizer units (101-1, 101-2, 201-1, 201-2, 301-1, 301-2, 401-1, 401-2, 501-1, 501-2, 601-1, 601-2, 701-1, 701-2) to generate a plane wave (211, 311) in a combined quiet zone (210, 310);
**characterized in that**
the at least two plane wave synthesizer units (101-1, 101-2, 201-1, 201-2, 301-1, 301-2, 401-1, 401-2, 501-1, 501-2, 601-1, 601-2, 701-1, 701-2) are arranged rotatably at least one of around a rotation axis that is parallel to the normal of the plane of main extension of the respective plane wave synthesizer unit (101-1, 101-2, 201-1, 201-2, 301-1, 301-2, 401-1, 401-2, 501-1, 501-2, 601-1, 601-2, 701-1, 701-2) and around a rotation axis that is orthogonal to the normal of the plane of main extension of the respective plane wave synthesizer unit (101-1, 101-2, 201-1, 201-2, 301-1, 301-2, 401-1, 401-2, 501-1, 501-2, 601-1, 601-2, 701-1, 701-2).

2. Plane wave synthesis system (100, 200, 300, 400, 500, 600, 700) according to claim 1, wherein each one of the antenna elements (102-11 - 102-1n, 102-21 - 102-2n, 502-11 - 502-1n, 502-21 - 502-2n, 602-11 - 602-1n, 602-21 - 602-2n, 702-11 - 702-1n, 702-21 - 702-2n) is single-polarized or dual-polarized.

3. Plane wave synthesis system (100, 200, 300, 400, 500, 600, 700) according to any one of the preceding claims, further comprising at least one signal distribution network to provide input signals (104-1, 104-2) for the antenna elements (102-11 - 102-1n, 102-21 - 102-2n, 502-11 - 502-1n, 502-21 - 502-2n, 602-11 - 602-1n, 602-21 - 602-2n, 702-11 - 702-1n, 702-21 - 702-2n) of the at least two plane wave synthesizer units (101-1, 101-2, 201-1, 201-2, 301-1, 301-2, 401-1, 401-2, 501-1, 501-2, 601-1, 601-2, 701-1, 701-2), especially based on the relative positions (105).

4. Plane wave synthesis system (100, 200, 300, 400, 500, 600, 700) according to claim 3, wherein the at least one signal distribution network comprises a power splitter (520) configured to split an input signal (504) into a dedicated input signal (104-1, 104-2) for each one of the at least two plane wave synthesizer units (101-1, 101-2, 201-1, 201-2, 301-1, 301-2, 401-1, 401-2, 501-1, 501-2, 601-1, 601-2, 701-1, 701-2).

5. Plane wave synthesis system (100, 200, 300, 400, 500, 600, 700) according to any one of claims 3 and 4, wherein the at least one signal distribution network is configured to set for each one of the input signals (104-1, 104-2) of the antenna elements (102-11 - 102-1n, 102-21 - 102-2n, 502-11 - 502-1n, 502-21 - 502-2n, 602-11 - 602-1n, 602-21 - 602-2n, 702-11 - 702-1n, 702-21 - 702-2n) a phase shift and an attenuation, especially based at least on one of characteristics of at least one of the antenna elements (102-11 - 102-1n, 102-21 - 102-2n, 502-11 - 502-1n, 502-21 - 502-2n, 602-11 - 602-1n, 602-21 - 602-2n, 702-11 - 702-1n, 702-21 - 702-2n), signal lines providing input signals (104-1, 104-2) to the antenna elements (102-11 - 102-1n, 102-21 - 102-2n, 502-11 - 502-1n, 502-21 - 502-2n, 602-11 - 602-1n, 602-21 - 602-2n, 702-11 - 702-1n, 702-21 - 702-2n), the power splitter (520), and the relative positions (105).

6. Plane wave synthesis system (100, 200, 300, 400, 500, 600, 700) according to claim 5, wherein setting the phase shift and attenuation with the at least one signal distribution network comprises determining the phase shift and attenuation based on an optimization algorithm that is configured to optimize the phase shift and attenuation according to predetermined characteristics of the combined quite zone.

7. Plane wave synthesis system (100, 200, 300, 400, 500, 600, 700) according to any one of the preceding claims, wherein the at least two plane wave synthesizer units (101-1, 101-2, 201-1, 201-2, 301-1, 301-2, 401-1, 401-2, 501-1, 501-2, 601-1, 601-2, 701-1, 701-2) are arranged next to each other, especially with their planes of main extension in parallel.

8. Plane wave synthesis system (100, 200, 300, 400, 500, 600, 700) according to any one of the preceding claims, wherein the at least two plane wave synthesizer units (101-1, 101-2, 201-1, 201-2, 301-1, 301-2, 401-1, 401-2, 501-1, 501-2, 601-1, 601-2, 701-1, 701-2) are arranged at least one of with a predetermined distance next to each other, and/or with a predetermined angle (315) to each other, especially with their planes of main extension not in parallel.

9. Plane wave synthesis system (100, 200, 300, 400, 500, 600, 700) according to any one of the preceding claims, further comprising electromagnetic coupling reduction means (418), especially a plate of conductive material or RF absorbing material, arranged between at least two of the at least two plane wave synthesizer units (101-1, 101-2, 201-1, 201-2, 301-1, 301-2, 401-1, 401-2, 501-1, 501-2, 601-1, 601-2, 701-1, 701-2).

10. Method for synthesizing a plane wave, the method comprising:
arranging (S1) at least two plane wave synthesizer units (101-1, 101-2, 201-1, 201-2, 301-1, 301-2, 401-1, 401-2, 501-1, 501-2, 601-1, 601-2, 701-1, 701-2) next to each other, each one of the plane wave synthesizer units (101-1, 101-2, 201-1, 201-2, 301-1, 301-2, 401-1, 401-2, 501-1, 501-2, 601-1, 601-2, 701-1, 701-2) comprising a plurality of antenna elements (102-11 - 102-1n, 102-21 - 102-2n, 502-11 - 502-1n, 502-21 - 502-2n, 602-11 - 602-1n, 602-21 - 602-2n, 702-11 - 702-1n, 702-21 - 702-2n) that are arranged at predetermined positions relative to a plane of main extension of the respective plane wave synthesizer unit (101-1, 101-2, 201-1, 201-2, 301-1, 301-2, 401-1, 401-2, 501-1, 501-2, 601-1, 601-2, 701-1, 701-2) and that are coupled to a signal input (103-1, 103-2) of the respective plane wave synthesizer unit (101-1, 101-2, 201-1, 201-2, 301-1, 301-2, 401-1, 401-2, 501-1, 501-2, 601-1, 601-2, 701-1, 701-2);
configuring (S2) the at least two plane wave synthesizer units (101-1, 101-2, 201-1, 201-2, 301-1, 301-2, 401-1, 401-2, 501-1, 501-2, 601-1, 601-2, 701-1, 701-2) based on the relative positions (105) between the at least two plane wave synthesizer units (101-1, 101-2, 201-1, 201-2, 301-1, 301-2, 401-1, 401-2, 501-1, 501-2, 601-1, 601-2, 701-1, 701-2);
providing (S3) an input signal (104-1, 104-2) to the at least two plane wave synthesizer units (101-1, 101-2, 201-1, 201-2, 301-1, 301-2, 401-1, 401-2, 501-1, 501-2, 601-1, 601-2, 701-1, 701-2) to generate a plane wave (211, 311) in a combined quiet zone (210, 310);
**characterized in that**
the at least two plane wave synthesizer units (101-1, 101-2, 201-1, 201-2, 301-1, 301-2, 401-1, 401-2, 501-1, 501-2, 601-1, 601-2, 701-1, 701-2) are arranged rotatably at least one of around a rotation axis that is parallel to the normal of the plane of main extension of the respective plane wave synthesizer unit (101-1, 101-2, 201-1, 201-2, 301-1, 301-2, 401-1, 401-2, 501-1, 501-2, 601-1, 601-2, 701-1, 701-2), and around a rotation axis that is orthogonal to the normal of the plane of main extension of the respective plane wave synthesizer unit (101-1, 101-2, 201-1, 201-2, 301-1, 301-2, 401-1, 401-2, 501-1, 501-2, 601-1, 601-2, 701-1, 701-2).

11. Method according to claim 10, further comprising distributing the input signal (504) via at least one signal distribution network, especially based on the relative positions (105), to provide input signals (104-1, 104-2) for the antenna elements (102-11 - 102-1n, 102-21 - 102-2n, 502-11 - 502-1n, 502-21 - 502-2n, 602-11 - 602-1n, 602-21 - 602-2n, 702-11 - 702-1n, 702-21 - 702-2n) of the at least two plane wave synthesizer units (101-1, 101-2, 201-1, 201-2, 301-1, 301-2, 401-1, 401-2, 501-1, 501-2, 601-1, 601-2, 701-1, 701-2), especially by splitting the input signal (504) to provide a dedicated input signal (104-1, 104-2) for each one of the at least two plane wave synthesizer units (101-1, 101-2, 201-1, 201-2, 301-1, 301-2, 401-1, 401-2, 501-1, 501-2, 601-1, 601-2, 701-1, 701-2); and/or
further comprising arranging electromagnetic coupling reduction means (418), especially a plate of conductive material or RF absorbing material, between at least two of the at least two plane wave synthesizer units (101-1, 101-2, 201-1, 201-2, 301-1, 301-2, 401-1, 401-2, 501-1, 501-2, 601-1, 601-2, 701-1, 701-2).

12. Method according to claim 11, wherein the signal distribution is configured by setting for each one of the input signals of the antenna elements (102-11 - 102-1n, 102-21 - 102-2n, 502-11 - 502-1n, 502-21 - 502-2n, 602-11 - 602-1n, 602-21 - 602-2n, 702-11 - 702-1n, 702-21 - 702-2n) a phase shift and an attenuation, especially based at least on one of characteristics of at least one of the antenna elements (102-11 - 102-1n, 102-21 - 102-2n, 502-11 - 502-1n, 502-21 - 502-2n, 602-11 - 602-1n, 602-21 - 602-2n, 702-11 - 702-1n, 702-21 - 702-2n), signal lines providing input signals (104-1, 104-2) to the antenna elements (102-11 - 102-1n, 102-21 - 102-2n, 502-11 - 502-1n, 502-21 - 502-2n, 602-11 - 602-1n, 602-21 - 602-2n, 702-11 - 702-1n, 702-21 - 702-2n), the power splitting, and the relative positions (105); and
especially wherein setting the phase shift and attenuation comprises determining the phase shift and attenuation based on an optimization algorithm that is configured to optimize the phase shift and attenuation according to predetermined characteristics of the combined quite zone.

13. Method according to any one of the preceding method-based claims, wherein the at least two plane wave synthesizer units (101-1, 101-2, 201-1, 201-2, 301-1, 301-2, 401-1, 401-2, 501-1, 501-2, 601-1, 601-2, 701-1, 701-2) are arranged next to each other, especially with their planes of main extension in parallel; and/or
wherein the at least two plane wave synthesizer units (101-1, 101-2, 201-1, 201-2, 301-1, 301-2, 401-1, 401-2, 501-1, 501-2, 601-1, 601-2, 701-1, 701-2) are arranged at least one of with a predetermined distance next to each other, and/or with a predetermined angle (315) to each other, especially with their planes of main extension not in parallel.

14. Method for testing RF equipment, the method comprising:
providing (S21) a plane wave synthesis system (100, 200, 300, 400, 500, 600, 700) according to any one of claims 1 to 9;
providing (S22) the RF equipment in the quiet zone (210, 310) generated by the plane wave synthesis system (100, 200, 300, 400, 500, 600, 700); and
performing (S23) RF tests on the RF equipment.

## Patentansprüche

1. System (100, 200, 300, 400, 500, 600, 700) für eine Synthese von ebenen Wellen, umfassend:
mindestens zwei Synthesizer-Einheiten (101-1, 101-2, 201-1, 201-2, 301-1, 301-2, 401-1, 401-2, 501-1, 501-2, 601-1, 601-2, 701-1, 701-2) für ebene Wellen, jede der Synthesizer-Einheiten (101-1, 101-2, 201-1, 201-2, 301-1, 301-2, 401-1, 401-2, 501-1, 501-2, 601-1, 601-2, 701-1, 701-2) für ebene Wellen umfassend eine Vielzahl von Antennenelementen (102-11 -102-1n, 102-21 - 102-2n, 502-11 - 502-1n, 502-21 - 502-2n, 602-11 - 602-1n, 602-21 - 602-2n, 702-11 - 702-1n, 702-21 - 702-2n), die an vorbestimmten Positionen relativ zu einer Haupterstreckungsebene der jeweiligen Synthesizer-Einheit (101-1, 101-2, 201-1, 201-2, 301-1, 301-2, 401-1, 401-2, 501-1, 501-2, 601-1, 601-2, 701-1, 701-2) für ebene Wellen angeordnet sind und die an einen Signaleingang (103-1, 103-2) der jeweiligen Synthesizer-Einheit (101-1, 101-2, 201-1, 201-2, 301-1, 301-2, 401-1, 401-2, 501-1, 501-2, 601-1, 601-2, 701-1, 701-2) für ebene Wellen gekoppelt sind;
wobei die mindestens zwei Synthesizer-Einheiten (101-1, 101-2, 201-1, 201-2, 301-1, 301-2, 401-1, 401-2, 501-1, 501-2, 601-1, 601-2, 701-1, 701-2) für ebene Wellen basierend auf den relativen Positionen (105) zwischen den mindestens zwei Synthesizer-Einheiten (101-1, 101-2, 201-1, 201-2, 301-1, 301-2, 401-1, 401-2, 501-1, 501-2, 601-1, 601-2, 701-1, 701-2) für ebene Wellen konfiguriert sind, um eine ebene Welle (211, 311) in einer kombinierten Ruhezone (210, 310) zu erzeugen;
**dadurch gekennzeichnet, dass**
die mindestens zwei Synthesizer-Einheiten (101-1, 101-2, 201-1, 201-2, 301-1, 301-2, 401-1, 401-2, 501-1, 501-2, 601-1, 601-2, 701-1, 701-2) für ebene Wellen mindestens eines von um eine Drehachse, die parallel zu der Normalen der Haupterstreckungsebene der jeweiligen Synthesizer-Einheit (101-1, 101-2, 201-1, 201-2, 301-1, 301-2, 401-1, 401-2, 501-1, 501-2, 601-1, 601-2, 701-1, 701-2) für ebene Wellen ist, und um eine Drehachse, die orthogonal zu der Normalen der Haupterstreckungsebene der jeweiligen Synthesizer-Einheit (101-1, 101-2, 201-1, 201-2, 301-1, 301-2, 401-1, 401-2, 501-1, 501-2, 601-1, 601-2, 701-1, 701-2) für ebene Wellen ist, drehbar angeordnet ist.

2. System (100, 200, 300, 400, 500, 600, 700) für die Synthese von ebenen Wellen nach Anspruch 1, wobei jedes der Antennenelemente (102-11 - 102-1n, 102-21 - 102-2n, 502-11 - 502-1n, 502-21 - 502-2n, 602-11 - 602-1n, 602-21 - 602-2n, 702-11 - 702-1n, 702-21 - 702-2n) einzelpolarisiert oder dualpolarisiert ist.

3. System (100, 200, 300, 400, 500, 600, 700) für die Synthese von ebenen Wellen nach einem der vorstehenden Ansprüche, ferner umfassend mindestens ein Signalverteilungsnetzwerk, um Eingangssignale (104-1, 104-2) für die Antennenelemente (102-11 - 102-1n, 102-21 - 102-2n, 502-11 - 502-1n, 502-21 - 502-2n, 602-11 - 602-1n, 602-21 - 602-2n, 702-11 - 702-1n, 702-21 - 702-2n) der mindestens zwei Synthesizer-Einheiten (101-1, 101-2, 201-1, 201-2, 301-1, 301-2, 401-1, 401-2, 501-1, 501-2, 601-1, 601-2, 701-1, 701-2) für ebene Wellen bereitzustellen, insbesondere basierend auf den relativen Positionen (105).

4. System (100, 200, 300, 400, 500, 600, 700) für die Synthese von ebenen Wellen nach Anspruch 3, wobei das mindestens eine Signalverteilungsnetzwerk einen Leistungsteiler (520) umfasst, der konfiguriert ist, um ein Eingangssignal (504) in ein dediziertes Eingangssignal (104-1, 104-2) für jede der mindestens zwei Synthesizer-Einheiten (101-1, 101-2, 201-1, 201-2, 301-1, 301-2, 401-1, 401-2, 501-1, 501-2, 601-1, 601-2, 701-1, 701-2) für ebene Wellen aufzuteilen.

5. System (100, 200, 300, 400, 500, 600, 700) für die Synthese von ebenen Wellen nach einem der Ansprüche 3 und 4, wobei das mindestens eine Signalverteilungsnetzwerk konfiguriert ist, um für jedes der Eingangssignale (104-1, 104-2) der Antennenelemente (102-11 - 102-1n, 102-21 - 102-2n, 502-11 - 502-1n, 502-21 - 502-2n, 602-11 - 602-1n, 602-21 - 602-2n, 702-11 - 702-1n, 702-21 - 702-2n) eine Phasenverschiebung und eine Dämpfung einzustellen, insbesondere basierend auf mindestens einer von Eigenschaften von mindestens einem der Antennenelemente (102-11 - 102-1n, 102-21 - 102-2n, 502-11 - 502-1n, 502-21 - 502-2n, 602-11 - 602-1n, 602-21 - 602-2n, 702-11 - 702-1n, 702-21 - 702-2n), wobei Signalleitungen die Eingangssignale (104-1, 104-2) an die Antennenelemente (102-11 -102-1n, 102-21 - 102-2n, 502-11 - 502-1n, 502-21 - 502-2n, 602-11 - 602-1n, 602-21 - 602-2n, 702-11 - 702-1n, 702-21 - 702-2n), den Leistungsteiler (520) und die relativen Positionen (105) bereitstellen.

6. System (100, 200, 300, 400, 500, 600, 700) für die Synthese von ebenen Wellen nach Anspruch 5, wobei das Einstellen der Phasenverschiebung und der Dämpfung mit dem mindestens einen Signalverteilungsnetzwerk das Bestimmen der Phasenverschiebung und der Dämpfung basierend auf einem Optimierungsalgorithmus umfasst, der konfiguriert ist, um die Phasenverschiebung und die Dämpfung gemäß vorbestimmten Eigenschaften der kombinierten Ruhezone zu optimieren.

7. System (100, 200, 300, 400, 500, 600, 700) für die Synthese von ebenen Wellen nach einem der vorstehenden Ansprüche, wobei die mindestens zwei Synthesizer-Einheiten (101-1, 101-2, 201-1, 201-2, 301-1, 301-2, 401-1, 401-2, 501-1, 501-2, 601-1, 601-2, 701-1, 701-2) für ebene Wellen nebeneinander angeordnet sind, insbesondere wobei ihre Haupterstreckungsebenen parallel sind.

8. System (100, 200, 300, 400, 500, 600, 700) für die Synthese von ebenen Wellen nach einem der vorstehenden Ansprüche, wobei die mindestens zwei Synthesizer-Einheiten (101-1, 101-2, 201-1, 201-2, 301-1, 301-2, 401-1, 401-2, 501-1, 501-2, 601-1, 601-2, 701-1, 701-2) für ebene Wellen mindestens eines von mit einem vorbestimmten Abstand nebeneinander und/oder mit einem vorbestimmten Winkel (315) zueinander angeordnet sind, insbesondere wobei ihre Haupterstreckungsebenen nicht parallel sind.

9. System (100, 200, 300, 400, 500, 600, 700) für die Synthese von ebenen Wellen nach einem der vorstehenden Ansprüche, ferner umfassend ein Mittel (418) zum Verringern von elektromagnetischer Kopplung, insbesondere eine Platte aus leitfähigem Material oder HF-absorbierendem Material, das zwischen mindestens zwei der mindestens zwei Synthesizer-Einheiten (101-1, 101-2, 201-1, 201-2, 301-1, 301-2, 401-1, 401-2, 501-1, 501-2, 601-1, 601-2, 701-1, 701-2) für ebene Wellen angeordnet ist.

10. Verfahren zum Synthetisieren einer ebenen Welle, das Verfahren umfassend:
Anordnen (S1) von mindestens zwei Synthesizer-Einheiten (101-1, 101-2, 201-1, 201-2, 301-1, 301-2, 401-1, 401-2, 501-1, 501-2, 601-1, 601-2, 701-1, 701-2) für ebene Wellen nebeneinander, jede der Synthesizer-Einheiten (101-1, 101-2, 201-1, 201-2, 301-1, 301-2, 401-1, 401-2, 501-1, 501-2, 601-1, 601-2, 701-1, 701-2) für ebene Wellen umfassend eine Vielzahl von Antennenelementen (102-11 - 102-1n, 102-21 - 102-2n, 502-11 - 502-1n, 502-21 - 502- 2n, 602-11 - 602-1n, 602-21 - 602-2n, 702-11 - 702-1n, 702-21 - 702-2n), die an vorbestimmten Positionen relativ zu einer Haupterstreckungsebene der jeweiligen Synthesizer-Einheit (101-1, 101-2, 201-1, 201-2, 301-1, 301-2, 401-1, 401-2, 501-1, 501-2, 601-1, 601-2, 701-1, 701-2) für ebene Wellen angeordnet sind und die an einen Signaleingang (103-1, 103-2) der jeweiligen Synthesizer-Einheit (101-1, 101-2, 201-1, 201-2, 301-1, 301-2, 401-1, 401-2, 501-1, 501-2, 601-1, 601-2, 701-1, 701-2) für ebene Wellen gekoppelt sind;
Konfigurieren (S2) der mindestens zwei Synthesizer-Einheiten (101-1, 101-2, 201-1, 201-2, 301-1, 301-2, 401-1, 401-2, 501-1, 501-2, 601-1, 601-2, 701-1, 701-2) für ebene Wellen basierend auf den relativen Positionen (105) zwischen den mindestens zwei Synthesizer-Einheiten (101-1, 101-2, 201-1, 201-2, 301-1, 301-2, 401-1, 401-2, 501-1, 501-2, 601-1, 601-2, 701-1, 701-2) für ebene Wellen;
Bereitstellen (S3) eines Eingangssignals (104-1, 104-2) an die mindestens zwei Synthesizer-Einheiten (101-1, 101-2, 201-1, 201-2, 301-1, 301-2, 401-1, 401-2, 501-1, 501-2, 601-1, 601-2, 701-1, 701-2) für ebene Wellen, um eine ebene Welle (211, 311) in einer kombinierten Ruhezone (210, 310) zu erzeugen;
**dadurch gekennzeichnet, dass**
die mindestens zwei Synthesizer-Einheiten (101-1, 101-2, 201-1, 201-2, 301-1, 301-2, 401-1, 401-2, 501-1, 501-2, 601-1, 601-2, 701-1, 701-2) für ebene Wellen mindestens von um eine Drehachse, die parallel zu der Normalen der Haupterstreckungsebene der jeweiligen Synthesizer-Einheit (101-1, 101-2, 201-1, 201-2, 301-1, 301-2, 401-1, 401-2, 501-1, 501-2, 601-1, 601-2, 701-1, 701-2) für ebene Wellen ist, und um eine Drehachse, die orthogonal zu der Normalen der Haupterstreckungsebene der jeweiligen Synthesizer-Einheit (101-1, 101-2, 201-1, 201-2, 301-1, 301-2, 401-1, 401-2, 501-1, 501-2, 601-1, 601-2, 701-1, 701-2) für ebene Wellen ist, drehbar angeordnet ist.

11. Verfahren nach Anspruch 10, ferner umfassend das Verteilen des Eingangssignals (504) über mindestens ein Signalverteilungsnetzwerk, insbesondere basierend auf den relativen Positionen (105), um Eingangssignale (104-1, 104-2) für die Antennenelemente (102-11 - 102-1n, 102-21 - 102-2n, 502-11 - 502-1n, 502-21 - 502-2n, 602-11 - 602-1n, 602-21 - 602-2n, 702-11 - 702-1n, 702-21 - 702-2n) der mindestens zwei Synthesizer-Einheiten (101-1, 101-2, 201-1, 201-2, 301-1, 301-2, 401-1, 401-2, 501-1, 501-2, 601-1, 601-2, 701-1, 701-2) für ebene Wellen bereitzustellen, insbesondere durch Aufteilen des Eingangssignals (504), um ein dediziertes Eingangssignal (104-1, 104-2) für jede der mindestens zwei Synthesizer-Einheiten (101-1, 101-2, 201-1, 201-2, 301-1, 301-2, 401-1, 401-2, 501-1, 501-2, 601-1, 601-2, 701-1, 701-2) für ebene Wellen bereitzustellen; und/oder
ferner umfassend das Anordnen eines Mittels (418) zum Verringern der elektromagnetischen Kopplung, insbesondere einer Platte aus leitfähigem Material oder HF-absorbierendem Material, das zwischen mindestens zwei der mindestens zwei Synthesizer-Einheiten (101-1, 101-2, 201-1, 201-2, 301-1, 301-2, 401-1, 401-2, 501-1, 501-2, 601-1, 601-2, 701-1, 701-2) für ebene Wellen angeordnet ist.

12. Verfahren nach Anspruch 11, wobei die Signalverteilung durch Einstellen für jedes der Eingangssignale der Antennenelemente (102-11 -102-1n, 102-21 - 102-2n, 502-11 - 502-1n, 502-21 - 502-2n, 602-11 - 602-1n, 602-21 - 602-2n, 702-11 - 702-1n, 702-21 - 702-2n) einer Phasenverschiebung und einer Dämpfung konfiguriert wird, insbesondere basierend mindestens auf einer von Eigenschaften von mindestens einem der Antennenelemente (102-11 - 102-1n, 102-21 - 102-2n, 502-11 - 502-1n, 502-21 - 502-2n, 602-11 - 602-1n, 602-21 - 602-2n, 702-11 - 702-1n, 702-21 - 702-2n), wobei Signalleitungen die Eingangssignale (104-1, 104-2) an die Antennenelemente (102-11 - 102-1n, 102-21 - 102-2n, 502-11 - 502-1n, 502-21 - 502-2n, 602-11 - 602-1n, 602-21 - 602-2n, 702-11 - 702-1n, 702-21 - 702-2n), das Leistungsaufteilen und die relativen Positionen (105) bereitstellen; und
insbesondere wobei das Einstellen der Phasenverschiebung und der Dämpfung das Bestimmen der Phasenverschiebung und der Dämpfung basierend auf einem Optimierungsalgorithmus umfasst, der konfiguriert ist, um die Phasenverschiebung und die Dämpfung gemäß vorbestimmten Eigenschaften der kombinierten Ruhezone zu optimieren.

13. Verfahren nach einem der vorstehenden verfahrensbasierten Ansprüche, wobei die mindestens zwei Synthesizer-Einheiten (101-1, 101-2, 201-1, 201-2, 301-1, 301-2, 401-1, 401-2, 501-1, 501-2, 601-1, 601-2, 701-1, 701-2) für ebene Wellen nebeneinander angeordnet sind, insbesondere wobei ihre Haupterstreckungsebenen parallel sind; und/oder
wobei die mindestens zwei Synthesizer-Einheiten (101-1, 101-2, 201-1, 201-2, 301-1, 301-2, 401-1, 401-2, 501-1, 501-2, 601-1, 601-2, 701-1, 701-2) für ebene Wellen mindestens eines von mit einem vorbestimmten Abstand nebeneinander und/oder mit einem vorbestimmten Winkel (315) zueinander angeordnet sind, insbesondere wobei ihre Haupterstreckungsebenen nicht parallel sind.

14. Verfahren zum Prüfen von HF-Ausrüstung, das Verfahren umfassend:
Bereitstellen (S21) eines Systems (100, 200, 300, 400, 500, 600, 700) für die Synthese von ebenen Wellen nach einem der Ansprüche 1 bis 9;
Bereitstellen (S22) der HF-Ausrüstung in der Ruhezone (210, 310), die durch das System (100, 200, 300, 400, 500, 600, 700) für die Synthese von ebenen Wellen erzeugt wird; und
Durchführen (S23) von HF-Tests an der HF-Ausrüstung.

## Revendications

1. Système de synthèse d'onde plane (100, 200, 300, 400, 500, 600, 700) comprenant :
au moins deux unités de synthétiseur d'onde plane (101-1, 101-2, 201-1, 201-2, 301-1, 301-2, 401-1, 401-2, 501-1, 501-2, 601-1, 601-2, 701-1, 701-2), chacune des unités de synthétiseur d'onde plane (101-1, 101-2, 201-1, 201-2, 301-1, 301-2, 401-1, 401-2, 501-1, 501-2, 601-1, 601-2, 701-1, 701-2) comprenant une pluralité d'éléments d'antenne (102-11 -102-1n, 102-21 - 102-2n, 502-11 - 502-1n, 502-21 - 502-2n, 602-11 - 602-1n, 602-21 - 602-2n, 702-11 - 702-1n, 702-21 - 702-2n) qui sont agencés à des positions prédéterminées par rapport à un plan d'extension principale de l'unité de synthétiseur d'onde plane (101-1, 101-2, 201-1, 201-2, 301-1, 301-2, 401-1, 401-2, 501-1, 501-2, 601-1, 601-2, 701-1, 701-2) respective et qui sont couplés à une entrée de signal (103-1, 103-2) de l'unité de synthétiseur d'onde plane (101-1, 101-2, 201-1, 201-2, 301-1, 301-2, 401-1, 401-2, 501-1, 501-2, 601-1, 601-2, 701-1, 701-2) respective ;
dans lequel les au moins deux unités de synthétiseur d'onde plane (101-1, 101-2, 201-1, 201-2, 301-1, 301-2, 401-1, 401-2, 501-1, 501-2, 601-1, 601-2, 701-1, 701-2) sont configurées en fonction des positions (105) relatives entre les au moins deux unités de synthétiseur d'onde plane (101-1, 101-2, 201-1, 201-2, 301-1, 301-2, 401-1, 401-2, 501-1, 501-2, 601-1, 601-2, 701-1, 701-2) pour générer une onde plane (211, 311) dans une zone de silence combinée (210, 310) ;
**caractérisé en ce que**
les au moins deux unités de synthétiseur d'onde plane (101-1, 101-2, 201-1, 201-2, 301-1, 301-2, 401-1, 401-2, 501-1, 501-2, 601-1, 601-2, 701-1, 701-2) sont agencées de manière rotative autour d'un axe de rotation qui est parallèle à la normale du plan d'extension principale de l'unité de synthétiseur d'onde plane (101-1, 101-2, 201-1, 201-2, 301-1, 301-2, 401-1, 401-2, 501-1, 501-2, 601-1, 601-2, 701-1, 701-2) respective et/ou autour d'un axe de rotation qui est orthogonal à la normale du plan d'extension principale de l'unité de synthétiseur d'onde plane (101-1, 101-2, 201-1, 201-2, 301-1, 301-2, 401-1, 401-2, 501-1, 501-2, 601-1, 601-2, 701-1, 701-2) respective.

2. Système de synthèse d'onde plane (100, 200, 300, 400, 500, 600, 700) selon la revendication 1, dans lequel chacun des éléments d'antenne (102-11 - 102-1n, 102-21 - 102-2n, 502-11 - 502-1n, 502-21 - 502-2n, 602-11 - 602-1n, 602-21 - 602-2n, 702-11 - 702-1n, 702-21 - 702-2n) est à simple polarisation ou à double polarisation.

3. Système de synthèse d'onde plane (100, 200, 300, 400, 500, 600, 700) selon l'une quelconque des revendications précédentes, comprenant en outre au moins un réseau de distribution de signaux pour fournir des signaux d'entrée (104-1, 104-2) pour les éléments d'antenne (102-11 - 102-1n, 102-21 - 102-2n, 502-11 - 502-1n, 502-21 - 502-2n, 602-11 - 602-1n, 602-21 - 602-2n, 702-11 - 702-1n, 702-21 - 702-2n) des au moins deux unités de synthétiseur d'onde plane (101-1, 101-2, 201-1, 201-2, 301-1, 301-2, 401-1, 401-2, 501-1, 501-2, 601-1, 601-2, 701-1, 701-2), en particulier en fonction des positions (105) relatives.

4. Système de synthèse d'onde plane (100, 200, 300, 400, 500, 600, 700) selon la revendication 3, dans lequel l'au moins un réseau de distribution de signaux comprend un diviseur de puissance (520) configuré pour diviser un signal d'entrée (504) en un signal d'entrée dédié (104-1, 104-2) pour chacune des au moins deux unités de synthétiseur d'onde plane (101-1, 101-2, 201-1, 201-2, 301-1, 301-2, 401-1, 401-2, 501-1, 501-2, 601-1, 601-2, 701-1, 701-2).

5. Système de synthèse d'onde plane (100, 200, 300, 400, 500, 600, 700) selon l'une quelconque des revendications 3 et 4, dans lequel l'au moins un réseau de distribution de signaux est configuré pour régler pour chacun des signaux d'entrée (104-1, 104-2) des éléments d'antenne (102-11 - 102-1n, 102-21 - 102-2n, 502-11 - 502-1n, 502-21 - 502-2n, 602-11 - 602-1n, 602-21 - 602-2n, 702-11 - 702-1n, 702-21 - 702-2n) un déphasage et une atténuation, en particulier en fonction d'au moins l'une des caractéristiques d'au moins l'un des éléments d'antenne (102-11 - 102-1n, 102-21 - 102-2n, 502-11 - 502-1n, 502-21 - 502-2n, 602-11 - 602-1n, 602-21 - 602-2n, 702-11 - 702-1n, 702-21 - 702-2n), de lignes de signaux fournissant des signaux d'entrée (104-1, 104-2) aux éléments d'antenne (102-11 -102-1n, 102-21 - 102-2n, 502-11 - 502-1n, 502-21 - 502-2n, 602-11 - 602-1n, 602-21 - 602-2n, 702-11 - 702-1n, 702-21 - 702-2n), du diviseur de puissance (520) et des positions relatives (105).

6. Système de synthèse d'onde plane (100, 200, 300, 400, 500, 600, 700) selon la revendication 5, dans lequel le réglage du déphasage et de l'atténuation avec l'au moins un réseau de distribution de signaux comprend la détermination du déphasage et de l'atténuation en fonction d'un algorithme d'optimisation qui est configuré pour optimiser le déphasage et l'atténuation selon des caractéristiques prédéterminées de la zone de silence combinée.

7. Système de synthèse d'onde plane (100, 200, 300, 400, 500, 600, 700) selon l'une quelconque des revendications précédentes, dans lequel les au moins deux unités de synthétiseur d'onde plane (101-1, 101-2, 201-1, 201-2, 301-1, 301-2, 401-1, 401-2, 501-1, 501-2, 601-1, 601-2, 701-1, 701-2) sont agencées l'une à côté de l'autre, en particulier avec leurs plans d'extension principale parallèles.

8. Système de synthèse d'onde plane (100, 200, 300, 400, 500, 600, 700) selon l'une quelconque des revendications précédentes, dans lequel les au moins deux unités de synthétiseur d'onde plane (101-1, 101-2, 201-1, 201-2, 301-1, 301-2, 401-1, 401-2, 501-1, 501-2, 601-1, 601-2, 701-1, 701-2) sont agencées avec une distance prédéterminée l'une à côté de l'autre, et/ou avec un angle prédéterminé (315) l'une par rapport à l'autre, en particulier avec leurs plans d'extension principale non parallèles.

9. Système de synthèse d'onde plane (100, 200, 300, 400, 500, 600, 700) selon l'une quelconque des revendications précédentes, comprenant en outre des moyens de réduction de couplage électromagnétique (418), en particulier une plaque de matériau conducteur ou de matériau absorbant RF, agencée entre au moins deux des au moins deux unités de synthétiseur d'onde plane (101-1, 101-2, 201-1, 201-2, 301-1, 301-2, 401-1, 401-2, 501-1, 501-2, 601-1, 601-2, 701-1, 701-2).

10. Procédé de synthèse d'une onde plane, le procédé comprenant :
l'agencement (S1) d'au moins deux unités de synthétiseur d'onde plane (101-1, 101-2, 201-1, 201-2, 301-1, 301-2, 401-1, 401-2, 501-1, 501-2, 601-1, 601-2, 701-1, 701-2) l'une à côté de l'autre, chacune des unités de synthétiseur d'onde plane (101-1, 101-2, 201-1, 201-2, 301-1, 301-2, 401-1, 401-2, 501-1, 501-2, 601-1, 601-2, 701-1, 701-2) comprenant une pluralité d'éléments d'antenne (102-11 - 102-1n, 102-21 - 102-2n, 502-11 - 502-1n, 502-21 - 502- 2n, 602-11 - 602-1n, 602-21 - 602-2n, 702-11 - 702-1n, 702-21 - 702-2n) qui sont agencés à des positions prédéterminées par rapport à un plan d'extension principale de l'unité de synthétiseur d'onde plane (101-1, 101-2, 201 -1, 201-2, 301-1, 301-2, 401-1, 401-2, 501-1, 501-2, 601-1, 601-2, 701-1, 701-2) respective et qui sont couplés à une entrée de signal (103-1, 103-2) de l'unité de synthétiseur d'onde plane (101-1, 101-2, 201-1, 201-2, 301-1, 301-2, 401-1, 401-2, 501-1, 501-2, 601-1, 601-2, 701-1, 701-2) respective ;
la configuration (S2) des au moins deux unités de synthétiseur d'onde plane (101-1, 101-2, 201-1, 201-2, 301-1, 301-2, 401-1, 401-2, 501-1, 501-2, 601-1, 601-2, 701-1, 701-2) en fonction des positions (105) relatives entre les au moins deux unités de synthétiseur d'onde plane (101-1, 101-2, 201-1, 201-2, 301-1, 301-2, 401-1, 401-2, 501-1, 501-2, 601-1, 601-2, 701-1, 701-2) ;
la fourniture (S3) d'un signal d'entrée (104-1, 104-2) aux au moins deux unités de synthétiseur d'onde plane (101-1, 101-2, 201-1, 201-2, 301-1, 301-2, 401-1, 401-2, 501-1, 501-2, 601-1, 601-2, 701-1, 701-2) pour générer une onde plane (211, 311) dans une zone de silence combinée (210, 310) ;
**caractérisée en ce que**
les au moins deux unités de synthétiseur d'onde plane (101-1, 101-2, 201-1, 201-2, 301-1, 301-2, 401-1, 401-2, 501-1, 501-2, 601-1, 601-2, 701-1, 701-2) sont agencées de manière rotative autour d'un axe de rotation qui est parallèle à la normale du plan d'extension principale de l'unité de synthétiseur d'onde plane (101-1, 101-2, 201-1, 201-2, 301-1, 301-2, 401-1, 401-2, 501-1, 501-2, 601-1, 601-2, 701-1, 701-2) respective et/ou autour d'un axe de rotation qui est orthogonal à la normale du plan d'extension principale de l'unité de synthétiseur d'onde plane (101-1, 101-2, 201-1, 201-2, 301-1, 301-2, 401-1, 401-2, 501-1, 501-2, 601-1, 601-2, 701-1, 701-2) respective.

11. Procédé selon la revendication 10, comprenant en outre la distribution du signal d'entrée (504) par le biais d'au moins un réseau de distribution de signaux, en particulier en fonction des positions relatives (105), pour fournir des signaux d'entrée (104-1, 104-2) pour les éléments d'antenne (102-11 - 102-1n, 102-21 - 102-2n, 502-11 - 502-1n, 502-21 - 502-2n, 602-11 - 602-1n, 602-21 - 602-2n, 702-11 - 702-1n, 702-21 - 702-2n) des au moins deux unités de synthétiseur d'onde plane (101-1, 101-2, 201-1, 201-2, 301-1, 301-2, 401-1, 401-2, 501-1, 501-2, 601-1, 601-2, 701-1, 701-2), en particulier en divisant le signal d'entrée (504) pour fournir un signal d'entrée dédié (104-1, 104-2) pour chacune des au moins deux unités de synthétiseur d'onde plane (101-1, 101-2, 201-1, 201-2, 301-1, 301-2, 401-1, 401-2, 501-1, 501-2, 601-1, 601-2, 701-1, 701-2) ; et/ou
comprenant en outre l'agencement de moyens de réduction de couplage électromagnétique (418), en particulier une plaque de matériau conducteur ou de matériau absorbant RF, entre au moins deux des au moins deux unités de synthétiseur d'onde plane (101-1, 101-2, 201-1, 201-2, 301-1, 301-2, 401-1, 401-2, 501-1, 501-2, 601-1, 601-2, 701-1, 701-2).

12. Procédé selon la revendication 11, dans lequel la distribution de signaux est configurée en réglant pour chacun des signaux d'entrée des éléments d'antenne (102-11 -102-1n, 102-21 - 102-2n, 502-11 - 502-1n, 502-21 - 502-2n, 602-11 - 602-1n, 602-21 - 602-2n, 702-11 - 702-1n, 702-21 - 702-2n) un déphasage et une atténuation, en particulier en fonction d'au moins l'une des caractéristiques d'au moins l'un des éléments d'antenne (102-11 - 102-1n, 102-21 - 102-2n, 502-11 - 502-1n, 502-21 - 502-2n, 602-11 - 602-1n, 602-21 - 602-2n, 702-11 - 702-1n, 702-21 - 702-2n), des lignes de signaux fournissant des signaux d'entrée (104-1, 104-2) aux éléments d'antenne (102-11 - 102-1n, 102-21 - 102-2n, 502-11 - 502-1n, 502-21 - 502-2n, 602-11 - 602-1n, 602-21 - 602-2n, 702-11 - 702-1n, 702-21 - 702-2n), de la division de puissance et des positions relatives (105) ; et
en particulier dans lequel le réglage du déphasage et de l'atténuation comprend la détermination du déphasage et de l'atténuation en fonction d'un algorithme d'optimisation qui est configuré pour optimiser le déphasage et l'atténuation en fonction de caractéristiques prédéterminées de la zone de silence combinée.

13. Procédé selon l'une quelconque des revendications de procédé précédentes, dans lequel les au moins deux unités de synthétiseur d'onde plane (101-1, 101-2, 201-1, 201-2, 301-1, 301-2, 401-1, 401-2, 501-1, 501-2, 601-1, 601-2, 701-1, 701-2) sont agencées l'une à côté de l'autre, en particulier avec leurs plans d'extension principale parallèles ; et/ou
dans lequel les au moins deux unités de synthétiseur d'onde plane (101-1, 101-2, 201-1, 201-2, 301-1, 301-2, 401-1, 401-2, 501-1, 501-2, 601-1, 601-2, 701-1, 701-2) sont agencées avec une distance prédéterminée l'une à côté de l'autre, et/ou avec un angle prédéterminé (315) l'une par rapport à l'autre, en particulier avec leurs plans d'extension principale non parallèles.

14. Procédé de test d'équipement RF, le procédé comprenant :
la fourniture (S21) d'un système de synthèse d'onde plane (100, 200, 300, 400, 500, 600, 700) selon l'une quelconque des revendications 1 à 9 ;
la fourniture (S22) de l'équipement RF dans la zone de silence (210, 310) générée par le système de synthèse d'onde plane (100, 200, 300, 400, 500, 600, 700) ; et
la réalisation (S23) de tests RF sur l'équipement RF.
